# FASCICULE DE BREVET EUROPEEN

(11) **EP 0 643 394 B1**
(45) Date de publication et mention de la délivrance du brevet: **20.10.1999**
(21) Numéro de dépôt: 94402002.3
(22) Date de dépôt: 08.09.1994
(51) Int. Cl.: G11C 7/00

(54) **Dispositif de comparaison des rythmes d'écriture et de lecture d'une mémoire-tampon**
Schreib-/Lesetaktvergleichungsanordnung für einen Pufferspeicher
Buffer memory read/write note comparison device

(30) Priorité: 10.09.1993 FR 9310824
(43) Date de publication de la demande: 15.03.1995
(73) Titulaire: ALCATEL, 75008 Paris (FR)
(72) Inventeur: Etienne, Jean-Paul, F-22700 Saint Quay-Perros (FR)
(74) Mandataire: Sciaux, Edmond

(56) Documents cités:
- EP-A- 0 391 584
- EP-A- 0 484 652
- US-A- 4 171 538
- US-A- 4 611 300
- US-A- 5 084 841

## Description

La présente invention concerne un dispositif de comparaison des rythmes d'écriture et de lecture d'une mémoire-tampon.

La présente invention est notamment applicable aux systèmes de transmission numériques utilisant de telles mémoires-tampons pour réaliser des opérations telles que, en réception, la restitution de signaux numériques transmis, avec filtrage de la gigue susceptible d'affecter ces signaux, ou, en émission, l'adaptation du rythme de signaux numériques à transmettre, au rythme offert pour leur transmission, par la technique connue dite de justification.

La présente invention concerne plus particulièrement le cas d'une mémoire-tampon composée d'une pluralité de points-mémoires élémentaires commandés sélectivement, en écriture et en lecture, par des moyens dits de commande, respectivement d'écriture et de lecture.

Le document EP-A-0 484 652 décrit un dispositif pour fournir une adresse d'écriture et une adresse de lecture à une mémoire tampon. Il comporte un compteur binaire unique qui fournit une adresse de lecture, et un additionneur qui déduit une adresser d'écriture à partir de cette adresser de lecture. Pour pouvoir synchroniser le changement d'état du compteur et l'addition réalisée par l'additionneur, il est prévu un dispositif de synchronisation. Il comporte en série : un transcodeur binaire / code de Gray, deux registres commandés par une même horloge, et un convertisseur code de Gray / binaire. Une incrémentation d'une unité dans le compteur se traduit par un changement du code de Gray qui ne porte que sur un seul bit à la fois. Cette propriété facilite la synchronisation réalisée par les deux registres. Le convertisseur code de Gray / binaire permet de restituer ensuite une valeur binaire utilisable pour l'adresse de lecture.

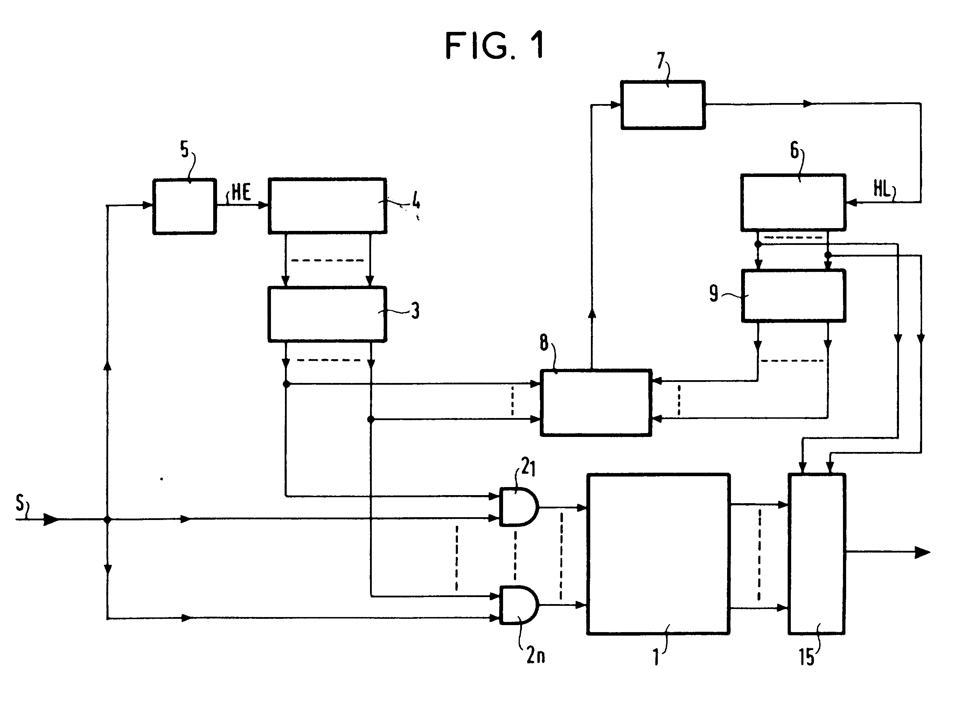

Par ailleurs, il est connu, comme rappelé sur la figure 1, de réaliser les moyens de commande d'écriture d'une telle mémoire-tampon, notée 1, et destinée, pour simplifier, à stocker des mots d'un seul élément binaire, au moyen d'un ensemble de portes logiques du type ET notées 2ₗ à 2ₙ (avec n égal au nombre de points-mémoires à commander) chacune de ces portes logiques recevant d'une part la suite S des éléments binaires à stocker dans cette mémoire-tampon et d'autre part l'un des n signaux de sortie, actifs à tour de rôle, d'un circuit, 3, de décodage d'états de comptage d'un compteur dit d'écriture, 4, incrémenté par un signal dit de rythme d'écriture, noté HE. Dans l'exemple d'application à un système de transmission numérique, correspondant plus particulièrement au cas illustré sur la figure 1, le signal de rythme d'écriture HE peut être issu d'un circuit dit de récupération de rythme, noté 5, recevant la suite S.

Il est en outre connu, comme rappelé sur cette même figure 1, de réaliser les moyens de commande de lecture de la mémoire-tampon 1 au moyen d'un multiplexeur, 15, recevant les signaux de sortie des différents points-mémoires de cette mémoire-tampon, et commandé en fonction des états de comptage d'un compteur dit de lecture, 6, incrémenté par un signal dit de rythme de lecture, noté HL. Dans l'exemple d'application à un système de transmission numérique, correspondant plus particulièrement au cas illustré sur la figure 1, le signal HL est lui-même issu d'un circuit, 7, d'élaboration de rythme de lecture de la mémoire-tampon, qui est commandé par un dispositif, 8, de comparaison des rythmes d'écriture et de lecture de cette mémoire-tampon, et qui comporte les éléments nécessaires pour permettre de réaliser l'une ou l'autre des opérations mentionnées plus haut.

Il est en outre connu, pour simplifier l'élaboration des signaux de commande du multiplexeur 15, d'utiliser comme compteur de lecture 6 un compteur binaire dont les états binaires de sortie commandent directement le multiplexeur 15.

Il est par ailleurs connu, pour simplifier la réalisation du circuit 3 de décodage d'états de comptage du compteur d'écriture, d'utiliser comme compteur d'écriture un compteur dit de Johnson.

Il est également connu, pour réaliser ladite comparaison de rythmes d'écriture et de lecture, d'utiliser un circuit, 8, de comparaison d'états de comptage des compteurs d'écriture et de lecture, ce circuit étant réalisé au moyen d'un ensemble de portes logiques recevant d'une part les signaux de sortie du circuit 3 de décodage d'états du compteur d'écriture 4, et d'autre part les signaux de sortie d'un circuit, 9, de décodage d'états de comptage du compteur de lecture 6.

Une telle façon de réaliser ladite comparaison de rythmes a pour inconvénient de nécessiter un nombre important de portes logiques, que ce soit pour la réalisation dudit circuit de comparaison d'états de comptage, particulièrement dans le cas de mémoire-tampon de grande capacité, ou parce qu'il nécessite également un circuit de décodage d'états de comptage du compteur de lecture.

Une telle façon de réaliser ladite comparaison de rythme a également pour inconvénient de ne pas permettre de déterminer aisément l'écart entre les rythmes d'écriture et de lecture, mais simplement de déterminer si cet écart est inférieur ou supérieur à un seuil prédéterminé, et à fortiori de ne pas permettre de traitements sur cet écart.

La présente invention permet notamment d'éviter ces inconvénients.

La présente invention a pour objet un dispositif de comparaison des rythmes d'écriture et de lecture d'une mémoire-tampon, ladite mémoire-tampon étant commandée, en écriture et en lecture, par des moyens de commande, respectivement d'écriture et de lecture, incluant un compteur d'écriture incrémenté par un signal de rythme d'écriture, et un compteur de lecture incrémenté par un signal de rythme de lecture ; l'un de ces compteurs étant un compteur binaire, et l'autre étant un compteur non binaire ; caractérisé en ce que ce dispositif de comparaison de rythmes comporte :
- associé au compteur non binaire, un moyen de comptage en binaire, incrémenté par le même signal de rythme que celui incrémentant le compteur non binaire,
- des moyens d'échantillonnage des états de comptage de ce moyen de comptage en binaire commandés par un signal de rythme dérivé du signal de rythme incrémentant le compteur binaire ;
- des moyens de comparaison des états binaires issus d'une part de ces moyens d'échantillonnage, et d'autre part du compteur binaire.

D'autres objets et caractéristiques de la présente invention apparaîtront à la lecture de la description suivante d'un exemple de réalisation, faite en relation avec les dessins ci-annexés, dans lesquels :
- la figure 1, déjà décrite, illustre un dispositif de comparaison des rythmes d'écriture et de lecture d'une mémoire-tampon, suivant l'art antérieur,
- la figure 2 illustre un dispositif de comparaison des rythmes d'écriture et de lecture d'une mémoire-tampon, suivant l'invention.

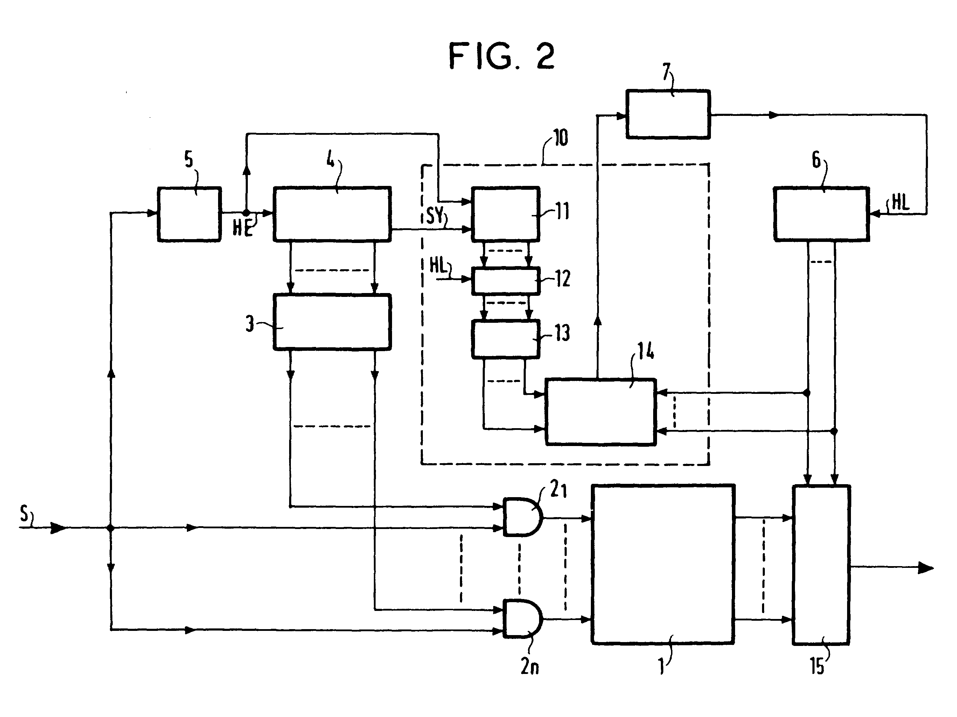

Sur la figure 2 est illustrée, comme sur la figure 1, une mémoire-tampon et ses moyens de commande d'écriture et de lecture, les éléments communs à la figure 1 et à la figure 2 étant désignés par les mêmes références.

La figure 2 correspond en outre, à titre d'exemple et comme la figure 1, au cas où le compteur d'écriture 4 est un compteur de Johnson, et le compteur de lecture 6 un compteur binaire.

Dans l'exemple illustré sur la figure 2, le dispositif, noté 10, de comparaison des rythmes d'écriture et de lecture de la mémoire-tampon comporte :
- un compteur dit en code de Gray, 11, incrémenté par le même signal de rythme que le compteur Johnson 4,
- des moyens, 12, pour échantillonner les états de comptage du compteur en code de Gray 11 par le signal HL de rythme de lecture de la mémoire-tampon,
- des moyens, 13, pour convertir en binaire les états de comptage issus des moyens 12,
- des moyens de comparaison proprement dits 14, permettant, à partir des valeurs binaires fournies d'une part par les moyens de conversion 13, et d'autre part par le compteur de lecture 6, de déterminer l'écart entre les rythmes d'écriture et de lecture de la mémoire-tampon, par différence entre lesdites valeurs binaires, et de réaliser tout traitement souhaité sur cet écart.

L'ensemble formé par le compteur en code de Gray 11 et par les moyens de conversion 13 constitue un moyen dit de comptage en binaire.

Dans l'exemple, considéré ici, où les états de comptage de ce moyen de comptage en binaire nécessitent d'être échantillonnés par un signal de rythme (en l'occurrence par le signal de rythme de lecture de la mémoire-tampon) pour permettre de réaliser ladite comparaison à un certain rythme (en l'occurrence au rythme de lecture de la mémoire-tampon) l'utilisation du compteur en code de Gray 11 permet d'éviter le problème de l'apparition, en sortie de ce compteur, d'états transitoires, susceptibles de se produire au moment dudit échantillonnage. Ce problème est évité grâce à la propriété d'un tel code selon laquelle deux états de comptage successifs d'un tel compteur ne se différencient que par la modification d'un seul élément binaire.

Dans le cas où ladite comparaison serait effectuée au rythme d'écriture de la mémoire-tampon, le compteur binaire de lecture serait de façon similaire remplacé par un moyen de comptage en binaire formé d'un compteur en code de Gray et de moyens de conversion Gray-binaire, et le compteur Johnson d'écriture serait alors associé à un moyen de comptage en binaire pouvant se réduire à un simple compteur en binaire.

Il est cependant évident que si la technologie dans laquelle sont réalisés les compteurs était telle que le problème des états transitoires en sortie de ces compteurs n'existait pas, alors ledit moyen de comptage en binaire pourrait se réduire à un compteur binaire.

On notera en outre que pour éviter tout défaut de synchronisation entre un compteur autre qu'un compteur binaire et le moyen de comptage en binaire qui lui est associé, dû par exemple à des perturbations sur le signal d'horloge commun qui leur est appliqué, ce moyen de comptage en binaire sera avantageusement synchronisé sur ce compteur, comme illustré sur la figure 2 où le compteur en code de Gray 11 reçoit un signal dit de synchronisation, SY, issu du compteur de Johnson 4, ce signal étant obtenu par exemple pour l'état de comptage zéro de ce compteur 4 et étant appliqué alors à des entrées dites de remise à zéro du compteur 11.

## Revendications

1. Dispositif de comparaison des rythmes d'écriture et de lecture d'une mémoire tampon (1), ladite mémoire-tampon étant commandée, en écriture et en lecture, par des moyens de commande, respectivement d'écriture et de lecture, incluant un compteur d'écriture (4) incrémenté par un signal de rythme d'écriture, et un compteur de lecture (6) incrémenté par un signal de rythme de lecture ; l'un (6) de ces compteurs étant un compteur binaire, et l'autre (4) étant un compteur non binaire;
**caractérisé** en ce que ce dispositif de comparaison de rythmes comporte :
- associé au compteur non binaire (4), un moyen de comptage en binaire (11, 13), incrémenté par le même signal de rythme (HE) que celui incrémentant le compteur non binaire,
- des moyens (12) d'échantillonnage des états de comptage de ce moyen de comptage en binaire (11,13), commandés par un signal de rythme dérivé du signal de rythme (HL) incrémentant le compteur binaire (6); - des moyens (14) de comparaison des états binaires issus d'une part de ces moyens d'échantillonnage (12), et d'autre part du compteur binaire (6).

2. Dispositif selon la revendication 1, **caractérisé** en ce que, ladite comparaison étant effectuée à un rythme autre que le rythme de comptage du compteur non binaire (4), ledit moyen de comptage en binaire (11,13) comporte un compteur en code de Gray (11), et des moyens (13) de conversion de code de Gray, en binaire, opérant sur les états issus de ce compteur en code de Gray.

## Patentansprüche

1. Vorrichtung zum Vergleichen von Schreib- und Lesetakt eines Pufferspeichers (1), wobei der Pufferspeicher bei Schreiben und Lesen durch Schreib- bzw. Lesesteuermittel gesteuert ist, mit einem durch ein Schreibtaktsignal inkrementierten Schreibzähler (4) und einem durch ein Lesetaktsignal inkrementierten Lesezähler (6), wobei einer dieser Zähler (6) ein binärer Zähler und der andere (4) ein nichtbinärer Zähler ist, dadurch gekennzeichnet, dass die Taktvergleichsvorrichtung umfasst:
- ein dem nichtbinären Zähler (4) zugeordnetes Binärzählmittel (11, 13), das durch das gleiche Taktsignal (HE) inkrementiert wird, das auch den nichtbinären Zähler inkrementiert,
- Abtastmittel (12) zum Abtasten von Zählzuständen dieses Binärzählmittels (11, 13), gesteuert durch ein Taktsignal, das von dem den binären Zähler (6) inkrementierenden Taktsignal (HL) abgeleitet ist;
- Vergleichsmittel (14) zum Vergleichen der einerseits aus den Abtastmitteln (12) und andererseits aus dem binären Zähler (6) hervorgegangenen binären Zustände.

2. Vorrichtung nach Anspruch 1, dadurch gekennzeichnet, dass wenn der Vergleich mit einem anderen Takt als dem Zähltakt des nichtbinären Zählers (4) durchgeführt wird, das Binärzählmittel (11, 13) einen Gray-Code-Zähler (11) und Umwandlungsmittel (13) zum Umwandeln von Gray-Code in Binärdarstellung umfasst, die auf die aus diesem Gray-Code-Zähler hervorgegangenen Zustände wirken.

## Claims

1. Apparatus for comparing the write and read rates of a buffer memory (1), said buffer memory being controlled in writing and in reading by write control means and read control means, respectively, including a write counter (4) incremented by a write clock signal and a read counter (6) incremented by a read clock signal, one of the counters (6) being a binary counter, and the other counter (4) being a non-binary counter;
**characterized** in that said rate comparison apparatus comprises:
· associated with the non-binary counter (4), binary count means (11, 13) incremented by the same clock signal (HE) as increments the non-binary counter;
· strobe means (12) sampling the count states of said binary counter means (11, 13) and controlled by a clock signal derived from the clock signal (HL) used for incrementing the binary counter (6); and
· comparator means (14) for comparing the binary states coming firstly from the strobe means (12) and secondly from the binary counter (6).

2. Apparatus according to claim 1, **characterized** in that with said comparison being performed at a rate other than the count rate of the non-binary counter (4), said binary count means (11, 13) comprises a Gray code counter (11), and converter means (13) for converting Gray code into binary, and operating on the states from said Gray code counter.
